# EUROPEAN PATENT SPECIFICATION

(11) **EP 2 548 995 B1**
(45) Date of publication and mention of the grant of the patent: **24.09.2014**
(21) Application number: 11756381.7
(22) Date of filing: 17.03.2011
(51) Int. Cl.: C23C 16/26, C23C 16/511, C23C 16/54, H01B 13/00

(54) **MANUFACTURING METHOD FOR TRANSPARENT CONDUCTIVE CARBON FILM**
HERSTELLUNGSVERFAHREN FÜR EINEN TRANSPARENTEN LEITFÄHIGEN KOHLENSTOFFFILM
PROCÉDÉ DE FABRICATION POUR UNE COUCHE DE CARBONE CONDUCTRICE TRANSPARENTE

(30) Priority: 28.02.2011 JP 2011041749; 20.01.2011 JP 2011009616; 08.09.2010 JP 2010200901; 17.03.2010 JP 2010060055
(43) Date of publication of application: 23.01.2013
(73) Proprietor: National Institute of Advanced Industrial Science and Technology, Tokyo 100-8921 (JP)
(72) Inventor: KIM Jaeho, Tsukuba-shi Ibaraki 305-8565 (JP); ISHIHARA Masatou, Tsukuba-shi Ibaraki 305-8565 (JP); KOGA Yoshinori, Tsukuba-shi Ibaraki 305-8565 (JP); TSUGAWA Kazuo, Tsukuba-shi Ibaraki 3058565 (JP); HASEGAWA Masataka, Tsukuba-shi Ibaraki 305-8565 (JP); IIJIMA Sumio, Tsukuba-shi Ibaraki 305-8565 (JP); YAMADA Takatoshi, Tsukuba-shi Ibaraki 305-8565 (JP)
(74) Representative: Peterreins, Frank
(86) International application number: PCT/JP2011/056352
(87) International publication number: WO 2011/115197

(56) References cited:
- WO-A1-2005/103326
- JP-A- 6 216 039
- JP-A- 2008 010 683
- JP-A- 2009 143 799
- US-A1- 2008 090 022
- ALEXANDER MALESEVIC ET AL: "Synthesis of few-layer graphene via microwave plasma-enhanced chemical vapour deposition", NANOTECHNOLOGY, IOP, BRISTOL, GB, vol. 19, no. 30, 30 July 2008 (2008-07-30) , page 305604, XP020136787, ISSN: 0957-4484
- KIM J ET AL: "Large-area surface wave plasmas using microwave multi-slot antennas for nanocrystalline diamond film deposition", PLASMA SOURCES SCIENCE AND TECHNOLOGY, INSTITUTE OF PHYSICS PUBLISHING, BRISTOL, GB, vol. 19, no. 1, 1 February 2010 (2010-02-01), page 15003, XP020175529, ISSN: 0963-0252
- XUESONG LI ET AL.: 'Large-area synthesis of high-quality and uniform graphene films on copper foils' SCIENCE vol. 324, 05 June 2009, pages 1312 - 1314, XP008127472
- G. D. YUAN ET AL.: 'Graphene sheets via microwave chemical vapor depositon' CHEMICAL PHYSICS LETTERS vol. 467, 2009, pages 361 - 364, XP025817310

## Description

### [Technical Field]

The present invention relates to a method for producing a transparent conductive carbon film which is used as a transparent conductive film or the like, and a transparent conductive carbon film.

### [Background Art]

A conductive planar crystal composed of sp2-bonded carbon atoms is called a "graphene film". The graphene film is disclosed in detail in Non-Patent Literature 1. The graphene film is a basic unit of a crystalline carbon film in various forms. Examples of the crystalline carbon film formed using a graphene film include a single-layer graphene formed using a single-layer graphene film, nanographene in the form of an about a few- to ten-layer laminate of a graphene film having a nanometer size, and a carbon nano wall in which an about several- to several tens-layer graphene film laminate is oriented at an angle which is nearly vertical to a base material surface (see Non-Patent Literature 2).

Use of a crystalline carbon film formed using a graphene film as a transparent conductive film or a transparent electrode is expected because of its high light transmittance and electric conductivity.

There have hitherto been developed, as a method for producing a graphene film, a method for peeling from natural graphite, a method for eliminating silicon by a high temperature heat treatment of silicon carbide, and a method for forming on various metal surfaces. Industrial use of a transparent conductive carbon film, which uses a crystalline carbon film formed using a graphene film, has been studied, thus there has been desired a high-throughput method for forming a film having a large area.

A method for forming a graphene film by a chemical vapor deposition (CVD) method has recently been developed (Non-Patent Literatures 3 and 4) . This method for forming a graphene film using a copper foil as a base material is performed by a thermal CVD method. In this technique, methane gas as a raw material gas is thermally decomposed at about 1, 000°C to form single-layer to a few-layer graphene film on a surface of the copper foil.

### [Citation List]

### [Non-Patent Literature]

[Non-Patent Literature 1]
   Kumi Yamada, Chemistry and Chemical Industry, 61(2008) pp.1123-1127
[Non-Patent Literature 2]
   Y. Wu, P. Qiao, T. Chong, Z. Shen, Adv. Mater. 14(2002) pp.64-67
[Non-Patent Literature 3]
   Xuesong Li, Weiwei Cai, Jinho An, Seyoung Kim, Junghyo Nah, Dongxing Yang, Richard Piner, Aruna Velamakanni, Inhwa Jung, Emanuel Tutuc, SanjayK. Banerjee, Luigi Colombo, RodneyS. Ruoff, Science, Vol. 324, 2009, pp.1312-1314.
[Non-Patent Literature 4]
   Xuesong Li, Yanwu Zhu, Weiwei Cai, Mark Borysiak, Boyang Han, David Chen, Richard D. Piner, Luigi Colombo, Rodney S . Ruoff, Nano Letters, Vol. 9, 2009, pp.4359-4363.
[Non-Patent Literature 5]
   L. G. Cancado, M. A. Pimenta, B. R. A. Neves, M. S. S. Dantas, A. Jorio, Phys. Rev. Lett. 93(2004), pp.247401_1-247401_4)
[Non-Patent Literature 6]
   L. M. Malard, M. A. Pimenta, G. Dresselhaus and M. S. Dresselhaus, Physics Reports 473 (2009), 51-87
[Non-Patent Literature 7]
   A. Reina, X. Jia, J. Ho, D. Nezich, H. Son, V. Bulovic, M. S. Dresselhaus and J. Kong, Nano Letters., Vol. 9 (2009), pp.30-35 & Supporting Information

### [Summary of Invention]

### [Technical Problem]

It is considered that the above-mentioned technique for forming a graphene film using a copper foil as a base material by a thermal CVD method is a promising method for industrially producing the transparent conductive carbon film, which is a crystalline graphene film.

However, it has been found that this technique is directed to processing by thermal CVD at high temperature close to a melting point of 1,080°C of copper, thus causing a problem such as a change in shape of a copper foil surface due to vaporization or recrystallization of copper during deposition of a graphene film.

There is also required, as a high-throughput method for forming a film having a large area, a technique in which a film is formed while continuously supplying a roll-shaped base material placed in the atmosphere into the film-forming region, and taking up on a take-up roll placed in the atmosphere. However, it is difficult to apply the technique by the thermal CVD method since the base material reaches a high temperature.

It is required to develop a film-forming technique which is performed at low temperature within a short reaction time as compared with an existing thermal CVD method so as to achieve industrial high throughput.

The present invention has been made in view of the above circumstances, and an object of the present invention is to solve problems such as high temperature processing and long processing time, which are issues of formation of a graphene film by thermal CVD, thereby providing a technique of forming a transparent conductive carbon film, which is a crystalline graphene film, at lower temperature within a short time.

### [Solution to Problem]

The present inventors have intensively studied so as to achieve the above object and found a novel technique for forming a graphene film at low temperature within a short time, whereby it is made possible to form a transparent conductive carbon film, which is a crystalline graphene film, at low temperature within a short time as compared with a conventional method, thus solving the above issues in the conventional technique.

The present invention has been accomplished based on these findings and includes the following.
[1] A method for producing a transparent conductive carbon film, according to claim 1, which includes the steps of:
   preparing a base material wound around a first roll, the base material being a thin film of copper or aluminum,
   drawing the base material from the roll and introducing into a microwave surface-wave plasma CVD apparatus,
   depositing a transparent conductive carbon filmon a surface of the base material by the microwave surface-wave plasma CVD apparatus by setting the temperature of the base material to 500°C or lower and the pressure to 50 Pa or less in a gas atmosphere in which an oxidation inhibitor as an additive gas for suppressing oxidation of the surface of the base material is added to a carbon-containing gas or a mixed gas of a carbon-containing gas and an inert gas,
   taking out the base material with the transparent conductive carbon film deposited thereon from the microwave surface-wave plasma CVD apparatus, and
   taking up the base material with the transparent conductive carbon film deposited on the base material on a second roll.
   Preferred embodiments of the present invention include the following.
[2] The method for producing a transparent conductive carbon film according to the above [1], which further includes the step of removing the carbon film from the base material on which the transparent conductive carbon film is deposited.
[3] The method for producing a transparent conductive carbon film according to the above [1], which further includes the step of transferring the base material on which the transparent conductive carbon film is deposited to the other base material.
[4] The method for producing a transparent conductive carbon film according to any one of the above [1] to [3], wherein the additive gas is hydrogen, and also the concentration of the carbon-containing gas or the carbon-containing gas in the mixed gas is from 30 to 100 mol% and the addition amount of the hydrogen gas is from 1 to 20 mol% based on the carbon-containing gas or the mixed gas.
[5] The method for producing a transparent conductive carbon film according to any one of the above [1] to [4], wherein a plurality of transparent conductive carbon films are deposited.

### [Advantageous Effects of Invention]

According to the method of the present invention, it becomes possible to solve problems such as high temperature processing and long processing time, which are issues of formation of a graphene film by conventional thermal CVD, thereby it is made possible to form a transparent conductive carbon film, which is a crystalline graphene film, at lower temperature within a short period of time. According to the microwave surface-wave plasma CVD method of the present invention, it is possible to reduce mixing of silicon-containing coarse particles into graphene as compared with a thermal CVD method as a conventional method, thus enabling suppression of segregation of impurities containing silicon.

### [Brief Description of Drawings]

Fig. 1 is a diagram schematically showing a microwave surface-wave plasma CVD apparatus used in the present invention.
Fig. 2 is a Raman scattering spectrum of a transparent conductive carbon film formed using copper as a base material, of Example 1.
Fig. 3 is a light transmission spectrum of a transparent conductive carbon film formed using copper as a base material, of Example 1.
Fig. 4 shows electric resistance (sheet resistance) of a transparent conductive carbon film formed using copper as a base material, of Example 1.
Fig. 5 is a Raman scattering spectrum of a transparent conductive carbon film formed using copper as a base material, of Example 2.
Fig. 6 is a Raman scattering spectrum of a transparent conductive carbon film formed using an aluminum foil as a base material, of Example 3.
Fig. 7 is a sectional view of a large-area microwave surface-wave plasma CVD apparatus used in Example 4.
Fig. 8 is a Raman scattering spectrum of a transparent conductive carbon film formed using copper as a base material, of Example 5.
Fig. 9 is a schematic diagram of an apparatus used in a thermal CVD method.
Fig. 10 is a bright field image of a film obtained by a microwave surface-wave plasma CVD method.
Fig. 11 is a bright field image of a film obtained by a thermal CVD method.
Fig. 12 shows EDS analytical results of a transparent conductive carbon film synthesized by a microwave surface-wave plasma CVD method.
Fig. 13 shows EDS analytical results of a transparent conductive carbon film synthesized by a thermal CVD method.
Fig. 14 is a TEM micrograph of a cross-section of a graphene film synthesized on a rolled copper foil base material of Example 7.
Fig. 15 is a diagram showing a relationship between the length and the number of a graphene sheet in a TEM micrograph shown in Fig. 14.
Fig. 16 shows photographs of a copper foil (area measuring 23 cm in width and 20 cm in length) after a plasma CVD treatment and a transparent conductive carbon film transferred to an acrylic plate, of Example 8.
Fig. 17 shows sheet resistance distribution of a transparent conductive carbon film (area measuring 23 cm × 20 cm) transferred to an acrylic plate, of Example 8.
Fig. 18 is a schematic diagram showing a continuous film-forming technique of a transparent conductive carbon film according to the present invention.
Fig. 19 is a schematic diagram showing a continuous film-forming technique of a transparent conductive carbon film using large area microwave surface-wave plasma CVD, of Example 10.
Fig. 20 is a Raman scattering spectrum of a transparent conductive carbon film obtained in Example 10.

### [Description of Embodiments]

The transparent conductive carbon film of the present disclosure can be obtained by mainly employing specific production conditions. In order to produce a transparent conductive carbon film, it is desired to use a surface-wave microwave plasma method capable of forming a large area film and to select the concentration and the molar ratio of a raw gas, the reaction time and the like, and to operate at comparatively low temperature.

In order to apply a CVD treatment for formation of a transparent conductive carbon film without causing a change in surface shape of a copper foil substrate and vaporization of a copper foil, it is preferable to perform a treatment at the temperature which is sufficiently lower than a melting point (1,080°C) of copper.

A usual microwave plasma CVD treatment is performed under the pressure of 2 × 10³ to 1 × 10⁴ Pa. Since plasma is less likely to diffuse under the above pressure and plasma concentrates in a narrow region, the temperature of a neutral gas in plasma becomes 1, 000°C or higher. Therefore, the temperature of the copper foil substrate is raised to 800°C or higher, resulting in enhanced vaporization of copper from a copper foil surface. Accordingly, it is impossible to apply the microwave plasma CVD treatment to the production of a transparent conductive carbon film. There is a limitation on uniform expansion of a plasma region, and it is difficult to form a highly uniform transparent conductive carbon film in a large area.

Accordingly, a plasma treatment under lower pressure is required so as to maintain the temperature of a copper foil substrate during film formation at low temperature and to form a highly uniform transparent conductive carbon film in a large area.

In the present invention, microwave surface-wave plasma capable of stably generating and maintaining plasma even under 10² Pa or less was generated and employed in a CVD treatment.

The microwave surface-wave plasma is disclosed in detail, for example, in the literature "Hideo Sugai, Plasma Electronics, Ohmsha, Ltd. 2000, p.124-125".

In this, it was possible to control to a temperature which is sufficiently lower than a melting point of a copper foil substrate and to generate uniform plasma in a large area measuring 380 mm and 340 mm or more.

As a result of diagnosis of plasma by a Langmuir Probe method (single probe method), it was confirmed that the plasma is surface-wave plasma capable of being generated and maintained by surface wave since the measured electron density is from 10¹¹ to 10¹²/cm³ and is more than 7.4 × 10¹⁰/cm³.

This Langmuir Probe method is disclosed in detail, for example, in the literature "Hideo Sugai, Plasma Electronics, Ohmsha, Ltd. 2000, p.58".

With respect to the conditions of a CVD treatment used in the present invention, the substrate temperature is 500°C or lower, and preferably from 200°C to 450°C.

The pressure is 50 Pa or less, preferably from 2 to 50 Pa, and more preferably from 5 to 20 Pa.

There is no particular limitation on the treatment time, and the treatment time was from about 1 to 600 seconds, and preferably from about 1 to 60 seconds. According to the treatment time controlled to such an extent, a transparent conductive carbon film having high light transmittance and electric conductivity can be obtained.

In the present invention, a raw gas (reactant gas) used in a microwave plasma CVD treatment is a carbon-containing gas or a mixed gas of the carbon-containing gas and an inert gas. The carbon-containing gas includes methane, ethylene, acetylene, ethanol, acetone, methanol and the like. The inert gas includes helium, neon, argon and the like.

In a carbon-containing gas or a mixed gas of the carbon-containing gas and an inert gas, the concentration of the carbon-containing gas is from 30 to 100 mol%, and preferably from 60 to 100 mol%. It is not preferable that the concentration of the carbon-containing gas be less than the above range since a problem such as a decrease in electric conductivity of a transparent conductive carbon film occurs.

In the present invention, it is preferable to use a gas in which an oxidation inhibitor for suppressing oxidation of a surface of the base material is added to the carbon-containing gas or the mixed gas. Hydrogen gas is preferably used as the additive gas, and acts as an oxidation inhibitor of a surface of a copper foil base material during a CVD treatment, thus exerting an action of promoting formation of a high transparent conductive carbon film having high electric conductivity. The addition amount of the hydrogen gas is preferably from 1 to 30 mol%, and more preferably from 1 to 20 mol%, based on the carbon-containing gas or the mixed gas.

### [Examples]

The present invention will be described below by way of Examples 9 and 10, and comparative Examples 1 to 8, but the present invention is not limited to these Examples.

The evaluation methods used in Examples will be described.

### «Raman Spectroscopy>>

Raman scattering spectrum of a transparent conductive carbon film formed by the technique of the present invention was measured.

The band, which is important in the evaluation by Raman scattering spectroscopy of a transparent conductive carbon film, which is a crystalline graphene film, includes 2D band, G band, D band and D' band. The G band is originated from a normal six-membered ring, and the 2D band is originated from overtone of the D band. The D band is also a peak attributed to defects of a normal six-membered ring. It is considered that the D' band is also a peak induced from defects, and is attributed to the edge portion of a laminate of an about several- to several tens-layer graphene film (above-mentioned Non-Patent Literature 5).

In a case both peaks of G band and 2D band are observed in the Raman scattering spectrum, the film is identified as a graphene film (above-mentioned Non-Patent Literature 3).

The above-mentionedNon-Patent Literature 6 discloses that peak positions of 2D band, G band, D band and D' band depend on the number of graphene films, and the excitation wavelength of laser during measurement of the Raman scattering spectrum. For example, in the case of laser having an excitation wavelength of 514.5 nm, peak positions of 2D band, G band, D band and D' band are generally about 2,700 cm⁻¹, 1,582 cm⁻¹, 1,350 cm⁻¹ and 1, 620 cm⁻¹. It is generally known that when the number of layers of graphene increases, the 2D band shifts to the high wavenumber side and the full width at half maximum extends. Furthermore, when the excitation wavelength of laser decreases, the 2D band shifts to the high wavenumber side.

Samples and measurement conditions used in the measurements in the respective Examples, detailed analysis of the transmittance spectrum will be described in the respective Examples.

### «Light Transmittance Measurement»

Light transmittance of a transparent conductive carbon film formed by the technique of the present invention was measured.

Samples obtained by removing a transparent conductive carbon film formed on a copper foil base material using the technique of the present invention from the copper foil and transferring the transparent conductive carbon film on a glass substrate were used. A substrate made of quartz glass measuring 10 mm in diameter and 1 mm in thickness or soda glass measuring 26 mm in width, 75 mm in length and 1 mm in thickness was used as the glass substrate.

Alight transmittance measurement apparatus used is Hitachi spectrophotometer U-1400, and the light transmittance at a wavelength range of 200 nm to 2,000 nm was measured. In the measurement, first, a light transmission spectrum of a quartz glass substrate alone (with no transparent conductive carbon film transferred thereon) was measured. Next, a light transmission spectrum of a quartz glass substrate with a transparent conductive carbon film transferred thereon was measured. The light transmission spectrum of the transparent conductive carbon film per se was determined by subtracting the light transmission spectrum of the quartz glass substrate with no transparent conductive carbon film transferred thereon from the light transmission spectrum of the quartz glass substrate with a transparent conductive carbon film transferred thereon. In the measurement and analysis, UV Solutions program for Hitachi spectrophotometer as measurement analysis computer software for the present apparatus was used.

Even in the case of using a soda glass substrate, Hitachi spectrophotometer U-1400 was used as the light transmittance measurement apparatus, and the light transmittance at a wavelength range of 200 nm to 2, 000 nmwas measured. In the first, a light transmission spectrum of a soda glass substrate alone (with no transparent conductive carbon film transferred thereon) was measured. Next, a light transmission spectrum of a soda glass substrate with a transparent conductive carbon film transferred thereon was measured. The light transmission spectrum of the transparent conductive carbon film per se was determined by subtracting the light transmission spectrum of the soda glass substrate with no transparent conductive carbon film transferred thereon from the light transmission spectrum of the soda glass substrate with a transparent conductive carbon film transferred thereon. In the measurement and analysis, UV Solutions program for Hitachi spectrophotometer as measurement analysis computer software for the present apparatus was used.

The light transmittance was evaluated by determining an average light transmittance at a wavelength of 400 nm to 800 nm in a visible range of the measured spectrum.

### «Conductivity»

Electric conductivity of a transparent conductive carbon film formedby the technique of the present invention was measured.

Samples obtained by removing a transparent conductive carbon film formed on a copper foil or aluminum foil base material using the technique of the present invention from the copper foil or aluminum foil and transferring the transparent conductive carbon film on an insulator substrate were used. A substrate made of polydimethylsiloxane (PDMS) (SILPOT184W/C, manufactured by Dow Corning Toray Co., Ltd.), quartz glass or soda glass was used as the insulator substrate.

In the evaluation of the electric conductivity, a low resistivity meter (Loresta-GP MCP-T600 manufactured by Mitsubishi Chemical Corporation) with a square probe (MCP-TPQPP, with a distance between electrodes of 1.5 mm) was used. The upper limit of a voltage to be applied between electrodes was set to 10 V or 90 V. Sheet resistance (surface resistivity) was measured by separating samples into lattice-shaped compartments, each measuring 2 cm in width, and pressing the square probe against the transparent conductive carbon film.

### «Electron Micrograph Observation»

Cross-section of a transparent conductive carbon film formed by the technique of the present invention was observed by an electron microscope.

Each sample for observation was sectioned by a focused ion beam (FIB) method after coating amorphous carbon on a transparent conductive carbon film. Xvision200TB manufactured by SII NanoTechnology Inc. was used as an apparatus. In transmission image observation by an electron microscope, H-9000UHR, manufactured by Hitachi, Ltd. was used and transmission image observation was carried out under the conditions of an acceleration voltage of 300 kV.

### Example 1

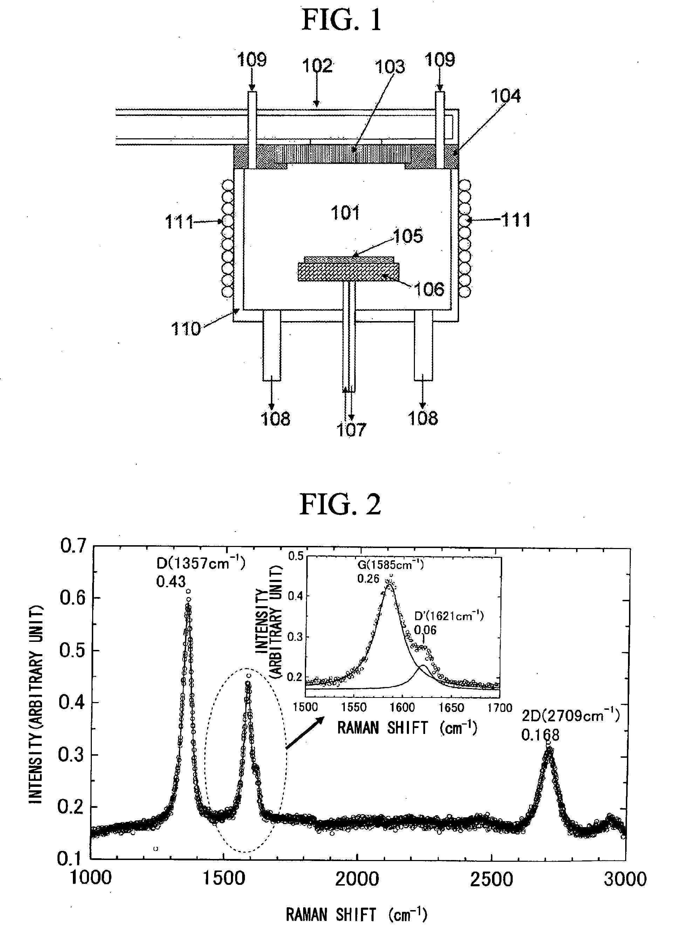

In the present Example, a copper foil measuring 100 mm × 100 mm and 33 µm in thickness and having surface roughness (arithmetic average roughness: Ra, the same shall apply hereinafter) of 54 nm was used as a base material, and a plasma CVD treatment was applied using a microwave surface-wave plasma CVD apparatus. Fig. 1 is a diagram schematically showing a microwave surface-wave plasma CVD apparatus used in the present invention.

Details of a microwave surface-wave plasma CVD treatment used in the present Example will be described below.

The microwave surface-wave plasma CVD apparatus used in the present invention is composed of a reaction vessel (110) made of metal, an upper end of which is opened; a quartz window (103) for introducing microwave, attached to the upper end portion of the reaction vessel (110) in an airtight manner through a supportingmember (104) madeof metal; andarectangularmicrowave waveguide (102) with a slot attached to the upper portion thereof.

In the present Example, a copper foil base material is disposed in the interior of the reaction vessel (110) and a CVD treatment is performed. The treatment procedure is as follows.

The copper foil base material (105) was disposed on a sample stage (106) provided inside a plasma generation chamber (101) in the microwave surface-wave plasma CVD reaction vessel (110). Next, the reaction chamber was evacuated to 1 × 10⁻³ Pa or less through an exhaust tube (108). A cooling water tube (111) is wound around the reaction chamber, and the reaction chamber was cooled by supplying cooling water thereto. The sample stage is made of copper and a sample was cooled by supplying cooling water through a supply/drain tube (107) of cooling water.

The height of the sample stage was adjusted such that a distance between a quartz window (103) and a copper foil base material becomes 50 mm.

Next, 100 SCCM of hydrogen gas was introduced into the reaction chamber through a gas introduction tube (109) for CVD treatment and the pressure inside the reaction chamber was maintained at 20 Pa using a pressure control valve connected to the exhaust tube (108).

Plasma was generated at microwave power of 3.0 kW and a surface treatment of a copper foil base material (105) with plasma was performed. The treatment time was 5 minutes. The temperature of a substrate during the plasma treatment was measured by bringing an alumel-chromel thermocouple into contact with a substrate surface. The temperature of the copper foil base material throughout the plasma CVD treatment was about 500°C. An oxide film and pollutants on the copper foil surface were removed by this plasma treatment.

Next, a gas for CVD treatment was introduced into the reaction chamber through the gas introduction tube (109) for CVD treatment. The gas for CVD treatment contained 25 SCCM of methane gas, 12.5 SCCM of argon gas and 5.0 SCCM of hydrogen gas and, therefore, the concentration of each raw gas was as follows: methane gas; 58.8mol%, argon gas; 29.4mol%, and hydrogen gas; 11.8 mol%. The pressure inside the reaction chamber was maintained at 10 Pa using a pressure control valve connected to the exhaust tube (108).

Plasma was generated at microwave power of 3.0 kW and a plasma CVD treatment of the copper foil base material (105) was performed. The temperature of the substrate during the plasma treatment was measured by bringing the alumel-chromel thermocouple into contact with the substrate surface. The temperature of the copper foil base material throughout the plasma CVD treatment was about 500°C. When the temperature of the copper foil base material during the plasma treatment becomes higher, excess action of plasma is exerted on the copper foil base material. Namely, excess etching action maybe sometimes exerted by exposing the copper foil base material to plasma, thus melting the copper foil, resulting in disappearance due to vaporization. Accordingly, it is essential to control the temperature of the base material sufficiently carefully. In order to prevent disappearance of the copper foil, it is preferable to maintain at 500°C or lower. As a result of the above plasma CVD treatment, a transparent conductive carbon thin film, which is a crystalline graphene film, was laminated on the copper foil base material, thus forming the laminate of a copper foil and a transparent conductive carbon thin film. The plasma CVD treatment time was 5 minutes.

Raman scattering spectrum of a transparent conductive carbon film obtained in the present Example was measured.

Samples obtained by removing a transparent conductive carbon film formed on a copper foil base material by the above technique and transferring the transparent conductive carbon film onto a silicon wafer with an oxide film manufactured by SUMCO Corporation were used. In the measurement, Laser Raman Spectrometer NRS-2100 manufactured by JASCO Corporation was used, and visible laser having a wavelength of 514.5 nm (Ar ion laser GLG2169, manufactured by Showa Optronics Co., Ltd.) was used as excitation light. Output of a laser source was 50 mW and a reducer was not used. An aperture size was 200 µm, and an object lens with magnification of 100 times was used. The exposure time was 10 seconds, and the measured values (five times) were accumulated to obtain a spectrum. Calibration of this apparatus was performed by a single crystal silicon wafer manufactured by SUMCO Corporation. Control was made such that the peak position of the Raman spectrum in this standard sample becomes a Raman shift of 520.5 cm⁻¹. In the measurement and analysis, standard computer software Spectra Manager for Windows (registered trademark) 95/98/NT ver.1.02.07 [Build 3] manufactured by JASCO Corporation was used.

An example of the measured Raman scattering spectrum of the transparent conductive carbon film is shown in Fig. 2.

In Fig. 2, peaks of both G band (1,585 cm⁻¹) and 2D band (2,709 cm⁻¹) are observed and, therefore, it is apparent that the transparent conductive carbon film of the present invention is a crystalline graphene film. In the case of graphite, which is a bulky crystalline carbon material, the 2D band shows a shape having a shoulder on the low wavenumber side. In the case of a graphene film, it shows a symmetrical shape. The peak width of the left half of a peak and that of the right half of a peak of the 2D band in Fig. 2 were measured. As a result, the peak width of the left half was 31.5 cm⁻¹ and that of the right half was 30.4 cm⁻¹, thus it was found that a peak has generally symmetrical shape. As is apparent therefrom, the transparent conductive thin film of the present disclosure is a graphene crystalline film. It is considered that the D' band is a peak induced from defects, and is attributed to the edge portion of a laminate of an about several- to several tens-layer graphene film.

It is possible to identify the number of graphene films using the relative intensity of peaks of the 2D band and G band (above-mentioned Non-Patent Literature 7). As shown in Fig. 2, the relative intensity of the respective peaks was determined by fitting the respective peaks using the Lorentz function and subtracting the background. The peak intensity was respectively as follows: I(2D) = 0.168, I(G) = 0.26. In a case a ratio of the intensity of the G band to that of the 2D band satisfies a relation: I(2D)/I(G) ≥ 1, the graphene film is a single- or two-layer graphene. In the three- or multi-layer graphene, the peak intensity is 1.0 or less.

As mentioned above, in an example of a transparent conductive carbon film shown in Fig. 2, the intensity ratio of the G band to the 2D band, and D' band are observed, thus it was found that the transparent conductive carbon film has a constitution in which the portion of a three- or multi-layer graphene film, and a laminate of an about several- to several tens-layer graphene film coexist.

Next, light transmittance of a transparent conductive carbon film obtained in the present Example was measured.

Samples obtained by removing a transparent conductive carbon film formed on a copper foil base material obtained in the present Example from the copper foil and transferring the transparent conductive carbon film on a quartz glass substrate measuring 10 mm in diameter and 1 mm in thickness were used.

Alight transmittance measurement apparatusused isHitachi spectrophotometer U-1400, and the light transmittance at a wavelength range of 200 nm to 2,000 nm was measured. In the measurement, first, a light transmission spectrum of a quartz glass substrate alone (with no transparent conductive carbon film transferred thereon) was measured. Next, a light transmission spectrum of a quartz glass substrate with a transparent conductive carbon film transferred thereon was measured. The light transmission spectrum of the transparent conductive carbon film per se was determined by subtracting the light transmission spectrum of the quartz glass substrate with no transparent conductive carbon film transferred thereon from the light transmission spectrum of the quartz glass substrate with a transparent conductive carbon film transferred thereon. In the measurement and analysis, UV Solutions program for Hitachi spectrophotometer as measurement analysis computer software for the present apparatus was used.

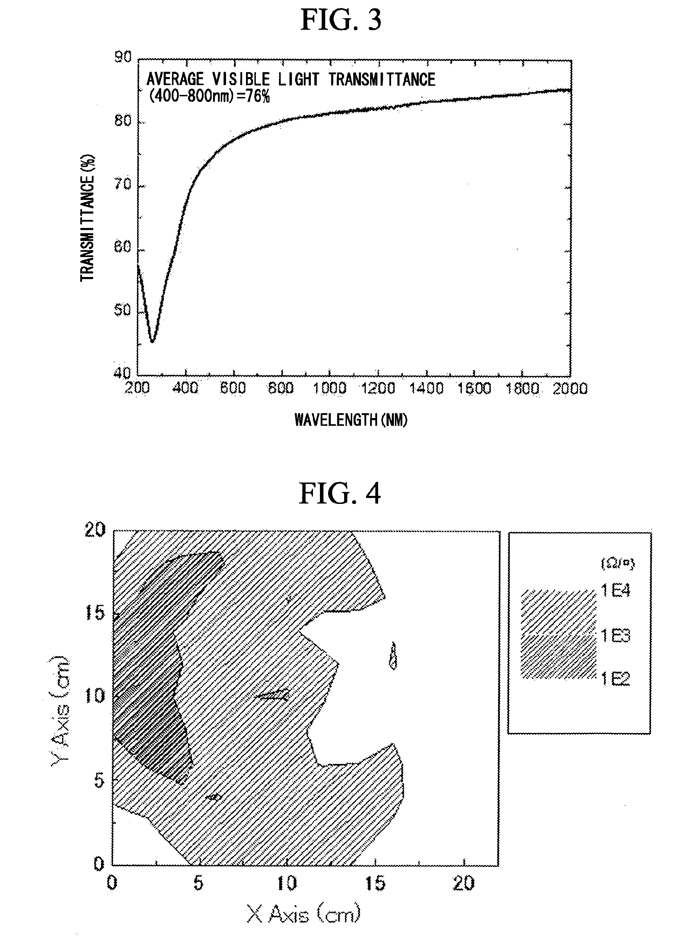

An example of the measured light transmission spectrum of the transparent conductive carbon film is shown in Fig. 3. An average light transmittance was determined by dividing the sum total of all measured values of the light transmittance at a wavelength of 400 nm to 800 nm in a visible range obtained from the spectrum by the number of the measured values. As a result, it was found that an average light transmittance is about 76% and the transparent conductive carbon film has very high transparency.

Electric conductivity of a transparent conductive carbon film obtained in the present Example was measured.

After fixing a transparent conductive carbon film formed on a copper foil base material measuring 24 cm in width and 21 cm in length obtained in the present Example on 2 mm thick polydimethylsiloxane (PDMS) (SILPOT 184 W/C, manufactured by Dow Corning Toray Co., Ltd.), only the copper foil was removed and the carbon films on PDMS as samples were used. In the evaluation of the electric conductivity, a low resistivity meter (Loresta-GP MCP-T600 manufactured by Mitsubishi Chemical Corporation) with a square probe (MCP-TPQPP, with a distance between electrodes of 1.5 mm) was used. The upper limit of a voltage to be applied between electrodes was set to 10 V or 90 V. Sheet resistance (surface resistivity) was measured by separating samples into lattice-shaped compartments, each measuring 2 cm in width, and pressing the square probe against the transparent conductive carbon film. With respect to the obtained sheet resistance values, a contour map was drawn using graph software (OriginPro 7.5J, manufactured by Origin Lab.).

An example of the measured sheet resistance of the transparent conductive carbon film is shown in Fig. 4. Based on this contour map, an area of the region having sheet resistance of 10⁴ Ω/sq or less was divided by an area of the entire contour map and, as a result, the area of the region having sheet resistance of 10⁴ Ω/sq or less accounted for 56% of the entire area. The region having the lowest resistance exhibited resistance of 490 Ω/sq. As mentioned above, it was found that the transparent conductive carbon film has very low resistance.

### Example 2

In the present Example, an ethylene gas was used as a carbon-containing gas and a plasma CVD treatment was applied using a microwave surface-wave plasma CVD apparatus shown in Fig. 1, in the same manner as in Example 1.

The treatment procedure in the present Example is as follows.

The copper foil base material (105) was disposed on a sample stage (106) provided inside a plasma generation chamber (101) in the microwave surface-wave plasma CVD reaction vessel (110). Next, the reaction chamber was evacuated to 1 × 10⁻³ Pa or less through an exhaust tube (108). A cooling water tube (111) is wound around the reaction chamber, and the reaction chamber was cooled by supplying cooling water thereto. The sample stage is made of copper and a sample was cooled by supplying cooling water through a supply/drain tube (107) of cooling water.

The height of the sample stage was adjusted such that a distance between a quartz window (103) and a copper foil base material becomes 50 mm.

Next, a gas for CVD treatment was introduced into the reaction chamber through a gas introduction tube (109) for CVD treatment. The gas for CVD treatment contained 15 SCCM of ethylene gas, 12.5 SCCM of argon gas and 5.0 SCCM of hydrogen gas and, therefore, the concentration of each raw gas was as follows: ethylene gas; 46.1 mol%, argon gas; 38.5 mol%, and hydrogen gas; 15.4mol%. The pressure inside the reaction chamber was maintained at 10 Pa using a pressure control valve connected to the exhaust tube (108).

Plasma was generated at microwave power of 3.0 kW and a plasma CVD treatment of the copper foil base material (105) was performed. The temperature of the substrate during the plasma treatment was measured by bringing the alumel-chromel thermocouple into contact with the substrate surface. The temperature of the copper foil base material throughout the plasma CVD treatment was about 400°C. When the temperature of the copper foil base material during the plasma treatment becomes higher, excess action of plasma is exerted on the copper foil base material. Namely, excess etching action maybe sometimes exerted by exposing the copper foil base material to plasma, thus melting the copper foil, resulting in disappearance due to vaporization. Accordingly, it is essential to control the temperature of the base material sufficiently carefully. In order to prevent disappearance of the copper foil, it is preferable to maintain at 500°C or lower. As a result of the above plasma CVD treatment, a transparent conductive carbon thin film, which is a crystalline graphene film, was laminated on the copper foil base material, thus forming a laminate of a copper foil and a transparent conductive carbon thin film. The plasma CVD treatment time was 10 minutes.

Raman scattering spectrum of the obtained transparent conductive carbon film was measured.

As samples, the transparent conductive carbon films formed on the copper base material by the above technique were used. The wavelength of laser for excitation was 638 nm, the spot size of the laser beam was 1 µm in diameter, a spectrometer was configured with 600 gratings, output of a laser source was 9 mW, and a reducer was not used. An aperture size was 100 µm, a slit size was 100 µm, and an object lens with magnification of 100 times was used. The exposure time was 30 seconds, and the measured values (five times) were accumulated to obtain a spectrum.

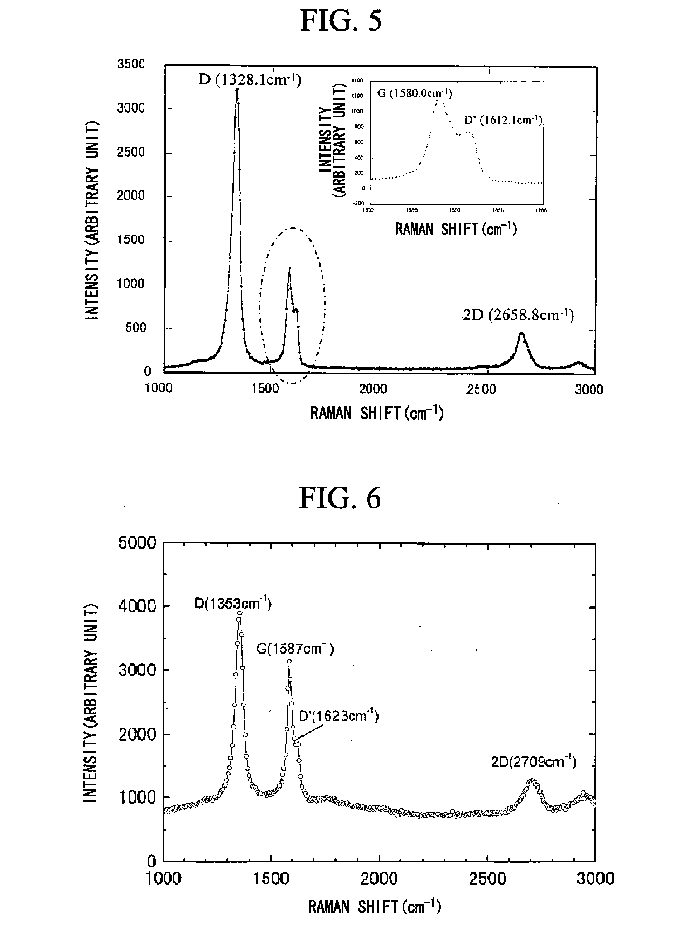

An example of the measured Raman scattering spectrum of the transparent conductive carbon film is shown in Fig. 5.

As shown in the drawing, peaks were observed at 2D band (2658.8 cm⁻¹), G band (1580.0 cm⁻¹), D band (1328.1 cm⁻¹), and D' band (1612.1 cm⁻¹).

In Fig. 5, peaks of both G band and 2D band are observed and, therefore, it is apparent that the transparent conductive carbon film obtained in the present Example is a crystalline graphene film. In the case of graphite, which is a bulky crystalline carbon material, the 2D band shows a shape having a shoulder on the low wavenumber side. In the case of a graphene film, it shows a symmetrical shape. The peak width of the left half of a peak and that of the right half of a peak of the 2D band in Fig. 5 were measured. As a result, the peak width of the left half was 28.3 cm⁻¹ and that of the right half was 30.7 cm⁻¹, thus it was found that a peak has almost symmetrical shape. As is apparent therefrom, the transparent conductive thin film of the present invention is a crystalline graphene film. It is considered that the D' band is a peak induced from defects, and is attributed to the edge portion of a laminate of an about several-to several tens-layer graphene film.

As mentioned above, according to the technique of the present invention, it is possible to form a transparent conductive carbon film, which is a crystalline graphene film, using ethylene as raw gas.

### Example 3

In the present Example, an aluminum foil measuring 25 cm × 20 cm and 12 µm in thickness was used as a base material and a CVD treatment is performed using a microwave surface-wave plasma CVD apparatus shown in Fig. 1 in the same manner as in Example 1.

The treatment procedure in the present Example is as follows.

The aluminium foil base material (105) was disposed on a sample stage (106) provided inside a plasma generation chamber (101) in the microwave surface-wave plasma CVD reaction vessel (110). Next, the reaction chamber was evacuated to 1 × 10⁻³ Pa or less through an exhaust tube (108). A cooling water tube (111) is wound around the reaction chamber, and the reaction chamber was cooled by supplying cooling water thereto. The sample stage is made of copper and a sample was cooled by supplying cooling water through a supply/drain tube (107) of cooling water.

The height of the sample stage was adjusted such that a distance between a quartz window (103) and an aluminum foil base material becomes 91 mm.

Next, 100 SCCM of hydrogen gas was introduced into the reaction chamber through a gas introduction tube (109) for CVD treatment and the pressure inside the reaction chamber was maintained at 20 Pa using a pressure control valve connected to the exhaust tube (108).

Plasma was generated at microwave power of 3.0 kW and a surface treatment of an aluminum foil base material (105) with plasma was performed. The treatment time was 5 minutes. The temperature of a substrate during the plasma treatment was measured by bringing an alumel-chromel thermocouple into contact with a substrate surface. The temperature of the aluminum foil base material throughout the plasma CVD treatment was about 310°C. An oxide film and pollutants on the aluminum foil surface were removed by this plasma treatment.

Next, the height of the sample stage was adjusted such that a distance between a quartz window (103) and an aluminum foil base material becomes 81 mm, and a gas for CVD treatment was introduced into the reaction chamber through a gas introduction tube (109) for CVD treatment. The gas for CVD treatment contained 25 SCCM of methane gas, 12.5 SCCM of argon gas and 0 SCCM of hydrogen gas and, therefore, the concentration of each raw gas was as follows: methane gas; 66.7 mol%, argon gas; 33.3 mol%, and hydrogen gas; 0 mol%. The pressure inside the reaction chamber was maintained at 10 Pa using a pressure control valve connected to the exhaust tube (108).

Plasma was generated at microwave power of 3.0 kW and a plasma CVD treatment of the aluminum foil base material (105) was performed. The temperature of the substrate during the plasma treatment was measured by bringing the alumel-chromel thermocouple into contact with the substrate surface. The temperature of the aluminum foil base material throughout the plasma CVD treatment was about 445°C. When the temperature of the aluminum foil base material during the plasma treatment becomes higher, excess action of plasma is exerted on the aluminum foil base material. Namely, excess etching action may be sometimes exerted by exposing the aluminum foil base material to plasma, thus melting the aluminum foil, resulting in disappearance due to vaporization. Accordingly, it is essential to control the temperature of the base material sufficiently carefully. In order to prevent disappearance of the aluminum foil, it is preferable to maintain at 450°C or lower. As a result of the above plasma CVD treatment, a transparent conductive carbon thin film, which is a crystalline graphene film, was laminated on the aluminum foil base material, thus forming a laminate of an aluminum foil and a transparent conductive carbon thin film. The plasma CVD treatment time was 3 minutes.

Raman scattering spectrum of a transparent conductive carbon film produced by the technique of the present invention was measured.

Samples were subjected to the measurement in a state where a transparent conductive carbon film formed on an aluminum foil base material by the technique of the present invention is in contact with the aluminum foil base material. A measurement apparatus is Model XploRA, manufactured by HORIBA, Ltd. The wavelength of laser for excitation was 532 nm, the spot size of the laser beam was 1 µm in diameter, a spectrometer was configured with 699 gratings, output of a laser source was 18.6 mW, and a reducer was not used. An aperture size was 100 µm, a slit size was 100 µm, and an object lens with magnification of 100 times was used. The exposure time was 20 seconds, and the measured values (three times) were accumulated to obtain a spectrum.

An example of the measured Raman scattering spectrum of the transparent conductive carbon film is shown in Fig. 6.

As shown in the drawing, peaks were observed at 2D band (2,709 cm⁻¹), G band (1,587 cm⁻¹), D band (1,353 cm⁻¹), and D' band (1, 623 cm⁻¹).

In Fig. 6, peaks of both G band and 2D band are observed, and a ratio of the intensity of the 2D band to that of the G band satisfies a relation: I(2D)/I(G) = 0.21. Therefore, it is apparent that the transparent conductive carbon film obtained in the present Example has a constitution in which the portion of a three- or multi-layer graphene film, and a laminate of an about several- to several tens-layer graphene film coexist (Non-Patent Literature 7 and Non-Patent Literature 3).

In the case of graphite, which is a bulky crystalline carbon material, the 2D band shows a shape having a shoulder on the low wavenumber side. In the case of a graphene film, it shows a symmetrical shape. The peak width of the left half of a peak and that of the right half of a peak of the 2D band in Fig. 6 were measured. As a result, the peak width of the left half was 39 cm⁻¹ and that of the right half was 34 cm⁻¹, thus it was found that a peak has almost symmetrical shape. As is apparent therefrom, the transparent conductive thin film of the present invention is a crystalline graphene film. It is considered that the D' band is a peak induced from defects, and is attributed to the edge portion of a laminate of an about several- to several tens-layer graphene film.

As mentioned above, according to the technique of the present invention in which the temperature is low and the reaction time is short as compared with a conventional thermal CVD method, it is possible to form a transparent conductive carbon film, which is a crystalline graphene film, using an aluminum foil as a base material.

### Example 4

In the present Example, a transparent conductive carbon film was synthesized using a large area plasma apparatus in which four microwave launchers for generating plasma are arranged and large-scale microwave surface-wave plasma is achieved (plasma treatment region: measuring 600 mm × 400 mm in cross-sectional area and 200 mm in height).

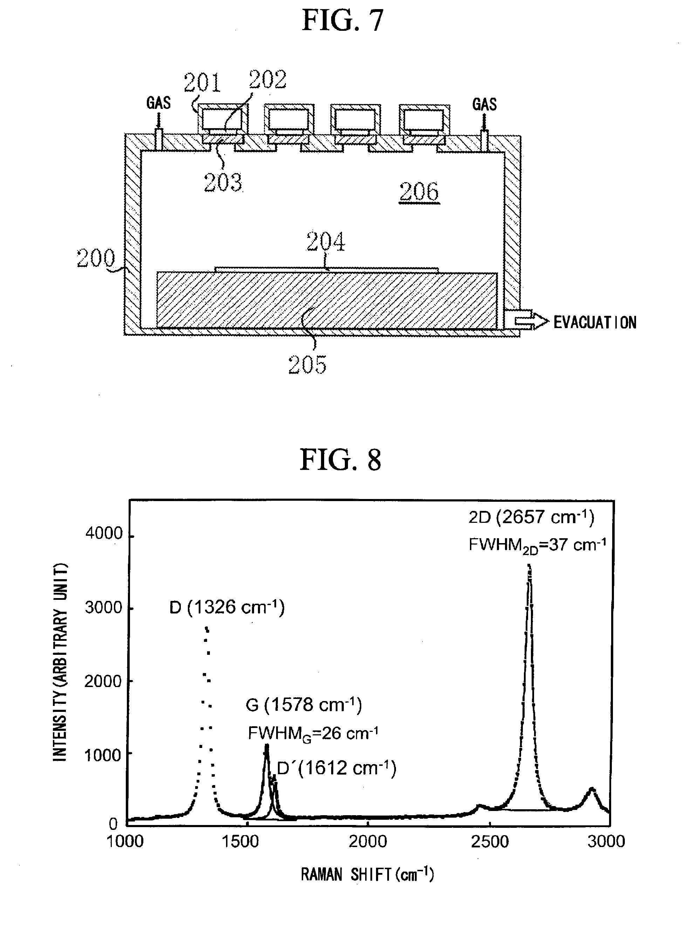

A sectional view of the apparatus is shown in Fig. 7. In the drawing, reference sign 200 denotes a discharge vessel, 201 denotes a rectangular wave guide, 202 denotes a slot antenna, 203 denotes a quartz window, 204 denotes a base material, 205 denotes a sample stage and 206 denotes a reaction chamber, respectively.

In the present Example, a copper foil measuring 15 mm × 15 mm and 25 µm in thickness and having surface roughness (Ra) of 54 nm was disposed in a reaction chamber (206), and a CVD treatment was performed. Test conditions are as follows.

Microwave power was set to 4.5 kW/one microwave launcher, and the pressure inside the discharge vessel was set to 5 Pa. A gas for CVD treatment contained 29 SCCM of methane gas, namely, 100 mol% of methane gas. In the present Example, a plasma CVD treatment was performed by varying a distance between a quartz window (203) and a copper foil base material within a range from 40 mm to 190 mm.

Since the sample stage (205) is not provided with a cooling unit, the copper foil base material was heated by heat of plasma. Throughout the plasma CVD treatment, the temperature of the copper foil base material was 280°C, 290°C or 340°C at the position which is 190 mm, 160 mm or 130 mm away from the quartz window, and no damage was observed in the copper foil base material after the CVD treatment. The temperature was higher than 500°C in a partial region at the position which is 40 mm away from the quartz window and, after the plasma CVD treatment, a surface of the copper foil base material was partially melted and vaporized, resulting in deformation and disappearance.

As a result of the above plasma CVD treatment, a transparent conductive carbon thin film was laminated on a copper foil base material, thus forming a laminate of a copper foil and a transparent conductive carbon thin film.

With respect to the plasma CVD treatment time, a transparent conductive carbon thin film having a thickness of several layers could be deposited by a treatment for 2 seconds or 5 minutes at the position which is 50 mm or 190 mm away from the quartz window.

### Example 5

A copper foil measuring 15 mm × 15 mm and 25 µm in thickness and having surface roughness (Ra) of 54 nm was disposed in a reaction chamber (206) in Fig. 7 and a CVD treatment was performed. Treatment conditions in the present Example are as follows.

Microwave power was set to 3 kW/one microwave launcher, and the pressure inside the discharge vessel was set to 5 Pa. The gas for CVD treatment contained 30 SCCM of methane gas, 10 SCCM of hydrogen gas and 20 SCCM of argon gas and, therefore, the concentration of each raw gas was as follows: methane gas; 50mol%, hydrogen gas; 16.7%, and argon gas; 33.3%. In the present Example, a plasma CVD treatment was performed at a distance between a quartz window (203) and a rolled copper foil base material of 110 mm.

Since the sample stage (205) is not provided with a cooling unit, the copper foil base material was heated by heat of plasma. In the plasma CVD treatment, the temperature of the rolled copper foil base material was 374°C, and no damage was observed in the rolled copper foil base material after the CVD treatment.

As a result of the above plasma CVD treatment, a transparent conductive carbon thin film was laminated on the copper foil base material, thus forming a laminate of a copper foil and a transparent conductive carbon thin film. The plasma CVD treatment time was 30 seconds.

Raman scattering spectrum of a transparent conductive carbon film produced by the technique of the present invention was measured.

Samples were subjected to the measurement in a state where a transparent conductive carbon film formed on a copper foil base material by the technique of the present invention is in contact with the copper foil base material. A measurement apparatus is Model XploRA, manufactured by HORIBA, Ltd. The wavelength of laser for excitation was 638 nm, the spot size of the laser beam was 1 micron in diameter, a spectrometer was configured with 699 gratings, output of a laser source was 11.8 mW, and a reducer was not used. An aperture size was 100 µm, a slit size was 100 µm, and an object lens with magnification of 100 times was used. The exposure time was 20 seconds, and the measured values (three times) were accumulated to obtain a spectrum.

An example of the measured Raman scattering spectrum of the transparent conductive carbon film is shown in Fig. 8.

As shown in the drawing, peaks were observed at 2D band (2,657 cm⁻¹), G band (1,587 cm⁻¹), D band (1,326 cm⁻¹), and D' band (1,612 cm⁻¹). It is possible to identify the number of graphene films using the relative intensity of peaks of the 2D band and G band (see Non-Patent Literature 7). As shown in Fig. 8, the relative intensity of the respective peaks was determined by fitting the respective peaks using the Lorentz function and subtracting the background. The peak intensity was respectively as follows: I(2D) = 3,418, I(G) = 997, I(D') = 463, and I(D) = 2,713. In a case a ratio of the intensity of the 2D band to that of the G band satisfies a relation: I(2D)/I(G) ≥ 1, the graphene film is a single- or two-layer graphene. In the three-or multi-layer graphene, the peak intensity is 1.0 or less.

In Fig. 8, peaks of both G band and 2D band are observed and a ratio of the intensity of the 2D band to that of the G band satisfies a relation: I(2D)/I(G) = 3.4 and, therefore, it is apparent that the transparent conductive carbon film obtained in the present Example is constituted of single-layer graphene film or two-layer graphene (see Non-Patent Literature 7 and Non-Patent Literature 3).

In the case of graphite, which is a bulky crystalline carbon material, the 2D band shows a shape having a shoulder on the low wavenumber side. In the case of a graphene film, it shows a symmetrical shape. The peak width of the left half of a peak and that of the right half of a peak of the 2D band in Fig. 8 were measured. As a result, the peak width of the left half was 19 cm⁻¹ and that of the right half was 18 cm⁻¹, thus it was found that a peak has almost symmetrical shape. As is apparent therefrom, the transparent conductive thin film of the present disclosure is formed using a single-layer graphene film or two-layer graphene. It is considered that the D' band is a peak induced from defects, and is attributed to the edge or defect portion of a laminate of a single-layer graphene film or two-layer graphene.

### Example 6

In the present Example, a CVD treatment was performed using a large area plasma apparatus in which four microwave launchers for generating plasma shown in Fig. 7 are arranged and large-scale microwave surface-wave plasma is achieved (plasma treatment region: measuring 600 mm × 400 mm in cross-sectional area and 200 mm in height).

In a microwave surface-wave plasma CVD method, a copper foil measuring 100 mm × 50 mm and 33 µm in thickness and having surface roughness (Ra) of 54 nm was disposed in a plasma CVD reaction vessel, and the height of the sample stage was adjusted such that a distance between a quartz window and a copper foil base material becomes 160 mm. The gas for plasma CVD treatment contained 30 SCCM of methane gas, 20 SCCM of argon gas and 10 SCCM of hydrogen gas, and the gas pressure inside the reaction vessel was maintained at 3Pa using a pressure control valve connected to a drain tube. Plasma was generated at microwave power of 18 kW and a plasma CVD treatment of a copper foil base material was performed. The plasma CVD treatment time was 30 seconds. The temperature of a base material was maintained at 450°C or lower.

A difference between graphene obtained by a microwave surface-wave plasma CVD method of the present Example and graphene obtained by a thermal CVD method was observed.

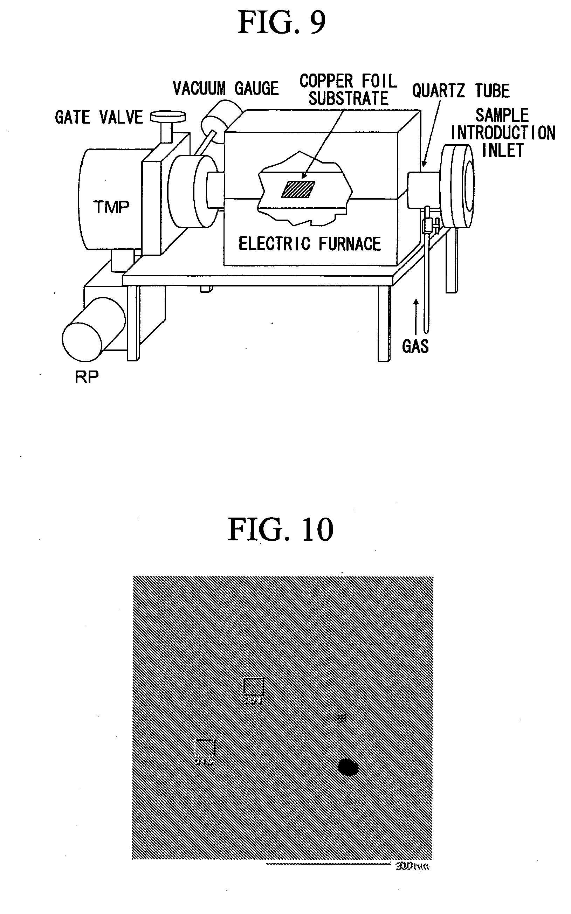

The thermal CVD method was performed using an evacuatable quartz tube furnace which uses a quartz tube as a furnace tube. A schematic diagram thereof is shown in Fig. 9.

A copper foil base material was placed at the center of the quartz tube, followed by evacuation up to 10⁻⁴ Pa or less. After heating to 1,000°C while allowing 2 SCCM of hydrogen gas to flow, 35 SCCM of methane gas was added while maintaining at 1,000°C, and a thermal CVD treatment of the copper foil base material was performed. The thermal CVD treatment time was 20 minutes.

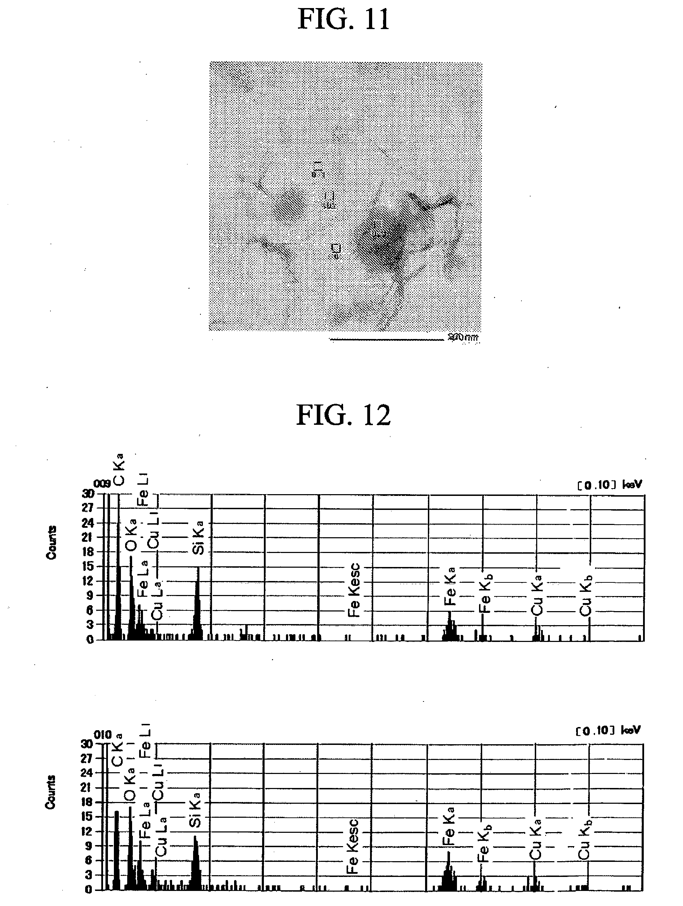

By the above-mentioned two methods, a transparent conductive carbon thin film, which would serve as a crystalline carbon film formed by a graphene film, was laminated on a copper foil base material, thus forming a laminate of a copper foil and a transparent conductive carbon thin film. With respect to the thus produced laminate, the copper foil was removed by dissolving in a 5% by weight ferric chloride solution, and then only the transparent conductive carbon film was subjected to impurity analysis by energy dispersive X-ray spectroscopy (EDS) of a transition electron micrograph (TEM). Bright field images of the film obtained by a microwave surface-wave plasma CVD method and a thermal CVD method are respectively shown in Fig. 10 and Fig. 11.

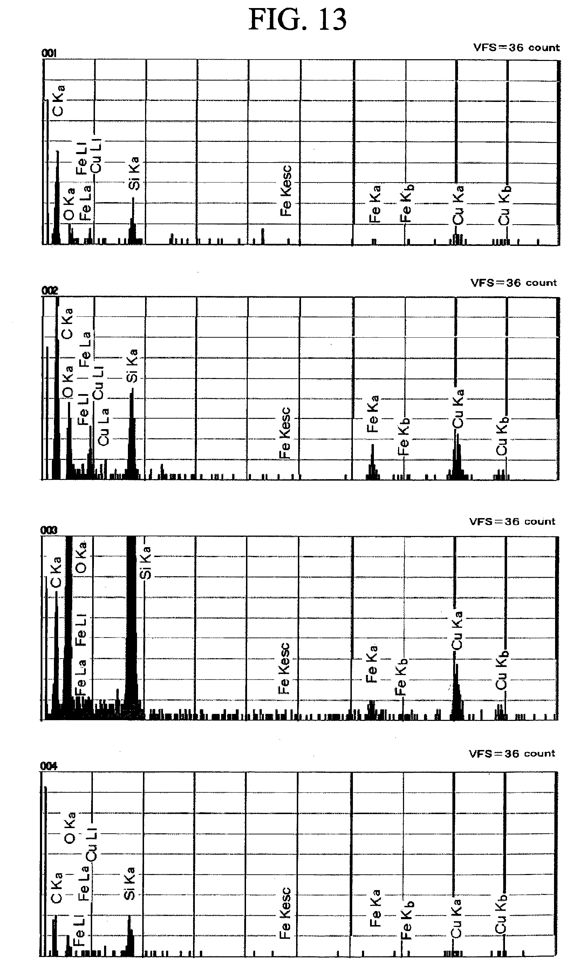

From the bright field images shown in Fig. 10 and Fig. 11, granular contrast of about 35 to 130 nm, which is not present in the film obtained by the microwave surface-wave plasma CVD method, can be observed in the film obtained by the thermal CVD method. Strong contrast of about 30 nm observed in Fig. 10 corresponds to the residue of ferric chloride after dissolving the copper foil. The results of EDS analysis within the squares in the fields of view of Fig. 10 and Fig. 11 are respectively shown in Fig. 12 and Fig. 13.

In the case of the microwave surface-wave plasma CVD method, 7.1 to 9.0 atom% of silicon and 17 to 20 atom% of oxygen were contained as impurities. Standard deviations were respectively 0.95 and 1.5. The atomic ratio obtained by dividing atom% of oxygen by atom% of silicon was 1.9 to 2.8, and the standard deviation was 0.45.

In contrast, in the case of the thermal CVD method, the content of silicon was dispersed in a range from 2.9 to 20.7 atom% and the content of oxygen was dispersed in a range from 1.9 to 57.1 atom%. Standard deviations were respectively 7.1 and 23. The atomic ratio obtained by dividing atom% of oxygen by atom% of silicon was dispersed in a range from 0.6 to 2.8, and standard deviation was 0.9.

The above test results reveal that the microwave surface-wave plasma CVD method can remarkably reduce mixing of Si-containing coarse particles of about 35 nm or more in the film and apparently suppress segregation of impurities including Si as compared with the thermal CVD method which is a conventional method.

### Example 7

In the present Example, a transparent conductive carbon thin film was synthesized by using a copper foil base material measuring 100 mm × 50 mm and 33 µm in thickness and having surface roughness (Ra) of 54 nm, using a CVD apparatus shown in Fig. 7. A copper foil base material was simultaneously placed in a plasma CVD reaction vessel, and then the height of the sample stage was adjusted such that a distance between a quartz window and a copper foil base material becomes 160 mm. The gas for plasma CVD contained 30 SCCM of methane gas, 20 SCCM of argon gas and 10 SCCM of hydrogen gas, and the gas pressure inside a reaction vessel was maintained at 3 Pa using a pressure control valve connected to a drain tube. Plasma was generated at microwave power of 18 kW and a plasma CVD treatment of the copper foil base material was performed. The CVD treatment time was 30 seconds. The temperature of the base material was maintained at 300°C or lower.

As a result of the above plasma CVD treatment, a transparent conductive carbon thin film, which is a crystalline graphene film, was laminated on the copper foil base material, thus forming a laminate of a copper foil and a transparent conductive carbon thin film.

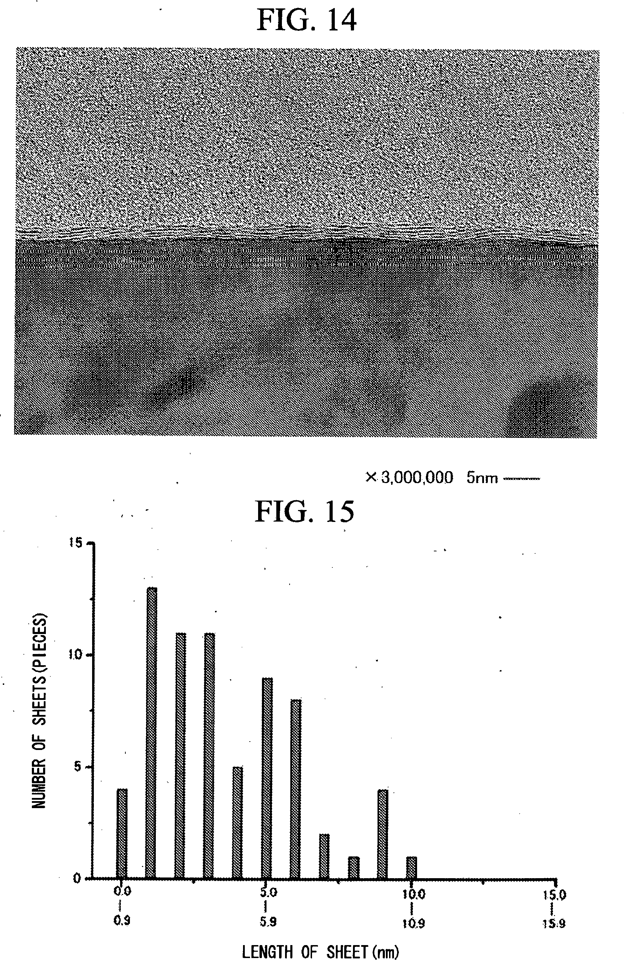

Transmission electron micrograph (TEM) measurement of cross-section of the laminate of a copper foil and a transparent conductive carbon thin film produced by the technique of the present invention was performed. The results are shown in Fig. 14.

From the TEMmeasurement results shown in Fig. 14, the length and the number of graphene sheets were determined. A graph showing a relation between the length and the number of graphene sheets is shown in Fig. 15. The average length of the graphene sheet was 4.1 nm. The average number of graphene films was 5.1.

The above test results reveal that it is possible to control characteristics of a transparent conductive carbon thin film composed of graphene sheets, which is synthesized by a plasma CVD treatment, by controlling a surface state of a copper foil base material.

### Example 8

In the present Example, a copper foil measuring 23 cm in width, 20 cm in length and 33 µm in thickness and having surface roughness (Ra) of 54 nm was used as a base material, and a plasma CVD treatment was performed using a CVD apparatus shown in Fig. 7. The gas for plasma CVD contained 30 SCCM of methane gas, 20 SCCM of argon gas and 10 SCCM of hydrogen gas. The gas pressure inside a reaction vessel was maintained at 3 Pa using a pressure control valve connected to a drain tube. Plasma was generated at microwave power of 18 kW and a plasma CVD treatment of the copper foil base material was performed. The CVD treatment time was 180 seconds. The height of the sample stage was adjusted such that a distance between a quartz window and a copper foil base material becomes 160 mm. The temperature of the base material was maintained at 400°C or lower.

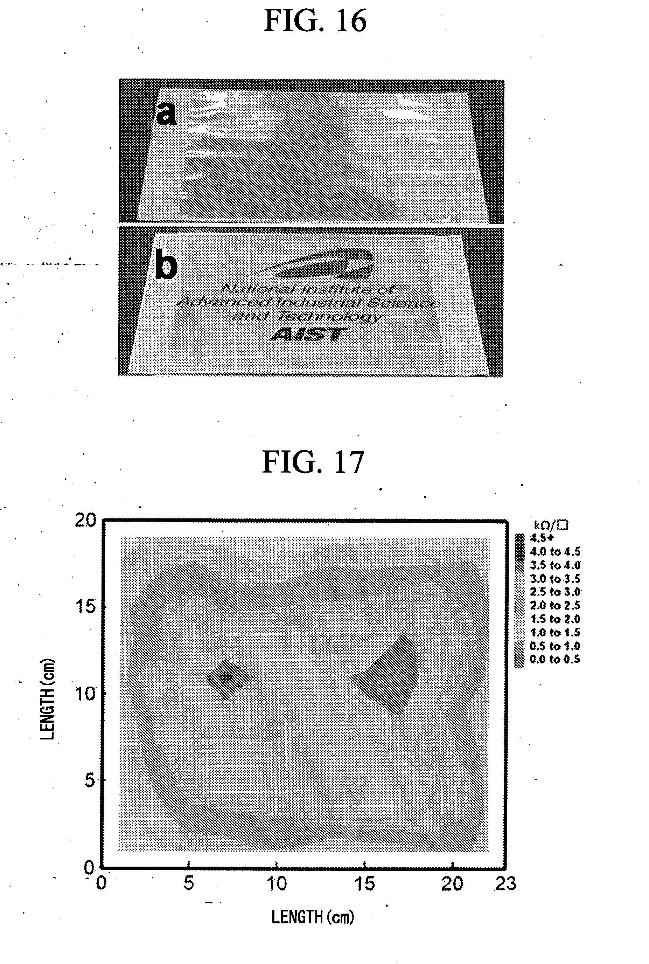

Spatial uniformity of electric conductivity of a transparent conductive carbon film produced by the above plasma CVD treatment was evaluated. After fixing the transparent conductive carbon film produced so as to evaluate electric conductivity to an acrylic plate, a transparent conductive carbon film was transferred onto the acrylic plate by removing only a copper foil. A photograph of a copper foil measuring 23 cm in width and 20 cm in length after a plasma CVD treatment, and a photograph of a transparent conductive carbon film transferred onto an acrylic plate are shown in Fig. 16.

Sheet resistance (surface resistivity) of the transparent conductive carbon film transferred onto the acrylic plate shown in Fig. 16 was measured. In the measurement of sheet resistance, a low resistivity meter, Loresta-GP MCP-T600, manufactured by Mitsubishi Chemical Corporation was used. The results are shown in Fig. 17.

The transparent conductive carbon film exhibits resistance in a range from 1.0 kΩ/sq to 4.2 kΩ/sq in an area measuring 23 cm in width and 20 cm in length. An area distribution rate of 1.0 to 3.0 kQ/sq is 79.2%, an area distribution rate of 1.0 to 3.5 kΩ/sq is 95.8%, and an area distribution rate of 1.0 to 4.0 kΩ/sq is 99.2%.

### Example 9

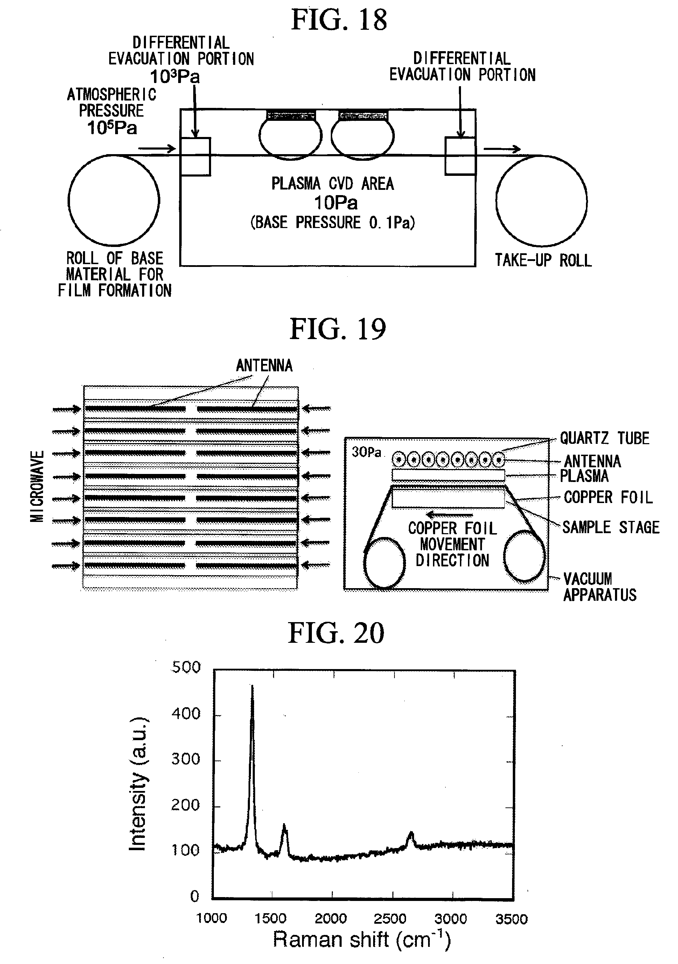

Using the technique for forming a transparent conductive carbon film by microwave surface-wave plasma CVD shown in Fig. 7 at low temperature within a short time of the present invention, a transparent conductive carbon film is formed while continuously supplying a roll-shaped copper foil base material placed in the atmosphere into a film-forming apparatus, and then the transparent conductive carbon film is continuously taken up by a take-up roll. Fig. 18 is a schematic diagram showing a continuous film-forming technique of this transparent conductive carbon film.

This continuous film-forming apparatus is composed of a plasma CVD area for formation of a transparent conductive carbon film, and a differential evacuation portion. The roll-shaped copper foil base material is disposed in the atmosphere. The pressure herein is atmospheric pressure, i.e., about 1 × 10⁵ Pa. A copper foil base material is supplied into the differential evacuation portion through an orifice for differential evacuation. The differential evacuation portion is evacuated by a mechanical booster pump and an auxiliary pump, and the pressure is maintained at about 1 × 10² Pa. For example, when using a copper foil measuring 400 mm in width and 33 µm in thickness and having surface roughness (Ra) of 54 nm, an orifice having a shape measuring 400 mm in width, 100 µm in height and 10 cm in length is used and a differential evacuation chamber is maintained at about 1 × 10² Pa by evacuating using a mechanical booster pump at an exhaust speed of 100 L/sec. The temperature of the base material is maintained at 450°C or lower.

The copper foil supplied into the differential evacuation chamber is supplied into a plasma CVD area through an orifice having the same shape as mentioned above disposed between the differential evacuation chamber and the plasma CVD area. In the plasma CVD area, a raw gas required for formation of a film contains 50 SCCM of methane gas, 33 SCCM of argon gas and 17 SCCM of hydrogen gas. The pressure inside a reaction vessel is maintained at about 10 Pa by a pressure control valve. Plasma was generated at microwave power of 18 kW and a plasma CVD treatment of the copper foil base material was performed. The height of the sample stage was adjusted such that a distance between a quartz window and a copper foil base material becomes 160 mm.

While the copper foil base material passes through the plasma CVD area, a transparent conductive carbon film is formed. In a case the length of the plasma CVD area is set to about 30 cm, the copper foil base material is supplied at a rate of about 10 cm per second.

The copper foil base material, which formed a transparent conductive carbon film in the plasma CVD area, is supplied into the differential evacuation portion through an orifice for differential evacuation, supplied into the atmosphere through the subsequent orifice for differential evacuation, and then taken up on a roll. As mentioned above, use of the technique of the present invention enables continuous formation of a transparent conductive carbon film on a copper foil base material, and this technique is an extremely advantageous technique from an industrial point of view.

### Example 10

In the present Example, a copper foil measuring 297 mm in width and 33 um in thickness and having surface roughness (Ra) of 54 nm was used as a base material, and a plasma CVD treatment was applied using a microwave surface-wave plasma CVD apparatus.

Fig. 19 is a schematic diagram of a continuous film-forming apparatus using microwave surface-wave plasma CVD used in the present Example. The right drawing is a sectional view, and the left drawing is a diagram showing a relation between the microwave introduction direction and the arrangement of an antenna in the apparatus.

As shown in the drawing, the apparatus used in the present Example is another example of the continuous film-forming apparatus, in which a roll-shaped base material is disposed in a vacuum vessel (plasma CVD area).

Details of the microwave surface-wave plasma CVD treatment used in the present Example will be described below.

It is necessary for the microwave surface-wave plasma CVD apparatus used in the present invention to use a surface-wave plasma generation apparatus capable of forming a large area film. Therefore, as shown in Fig. 19, quartz tubes are used as a dielectric material which covers the antennas. The quartz tube has an outer diameter of 38 mm.

In the present invention, an A4 width roll-shaped copper foil base material is disposed inside a reaction vessel, and a CVD treatment is performed while taking up a roll. While the A4 width roll-shaped copper foil base material passes through a sample stage of 48 cm in length, a film is formed. The treatment procedure is as follows.

The roll-shaped copper foil base material and a taking up mechanismwere disposed so as to interpose a sample stage, provided inside a plasma generation chamber in a microwave surface-wave plasma CVD reaction vessel, therebetween. A copper foil base material was disposed on the sample stage. Next, the reaction chamber was evacuated to 1 Pa or less through an exhaust tube. A cooling water tube is wound around the reaction chamber, and the reaction chamber was cooled by supplying cooling water thereto. The sample stage is made of copper and a sample was cooled by supplying cooling water through a supply/drain tube of cooling water.

The height of the sample stage was adjusted such that a distance between a quartz window and a copper foil base material becomes 50 mm. Next, a gas for CVD treatment was introduced into the reaction chamber through a gas introduction tube for CVD treatment. The gas for CVD treatment contained 50 SCCM of methane gas, 20 SCCM of argon gas and 30 SCCM of hydrogen gas and, therefore, the concentration of each raw gas was as follows: methane gas; 50 mol%, argon gas; 20 mol%, and hydrogen gas; 30 mol%. The pressure inside the reaction chamber was maintained at 3 Pa using a pressure control valve connected to the exhaust tube.

Plasma was generated at microwave power of 6.0 kW and a plasma CVD treatment of the copper foil base material was performed. The take-up rate of the copper foil was set to a given rate of 2 to 5 mm/sec. Taking the length (48 cm) of the sample stage exposed to plasma into consideration, the film formation times is from 96 to 240 seconds. The temperature of the substrate during the plasma treatment was measured by bringing the alumel-chromel thermocouple into contact with the substrate surface. The temperature of the copper foil base material throughout the plasma CVD treatment was about 400°C. Excess etching action may be sometimes exerted by exposing the copper foil base material to plasma, thus melting the copper foil, resulting in disappearance due to vaporization. Accordingly, it is essential to control the temperature of the base material sufficiently carefully. In order to prevent disappearance of the copper foil, it is preferable to maintain at 400°C or lower. As a result of the above plasma CVD treatment, a transparent conductive carbon thin film, which is a crystalline graphene film, was laminated on the copper foil base material, thus forming a laminate of a copper foil and a transparent conductive carbon thin film.

Raman scattering spectrum of the transparent conductive carbon film obtained in the present Example was measured.

Samples were subjected to the measurement in a state where a transparent conductive carbon film formed on a copper foil base material by the technique of the present invention is in contact with the copper foil base material. In order to evaluate uniformity inside the transparent conductive carbon thin film, an A4 width sample was divided into seven equal parts and then Raman scattering spectra were measured. A measurement apparatus is Model XploRA, manufactured by HORIBA, Ltd. The wavelength of laser for excitation was 638 nm, the spot size of the laser beam was 1 µm in diameter, a spectrometer was configured with 600 gratings, output of a laser source was 9 mW, and a reducer was not used. An aperture size was 100 µm, a slit size was 100 µm, and an object lens with magnification of 100 times was used. The exposure time was 30 seconds, and the measured values (five times) were accumulated to obtain a spectrum.

An example of the measured Raman scattering spectrum of the transparent conductive carbon film is shown in Fig. 20.

As shown in the drawing, peaks were observed at 2D band (2652.3 cm⁻¹), G band (1592.6 cm⁻¹), D band (1322.5 cm⁻¹), and D' band (1616.9 cm⁻¹).

In Fig. 20, peaks of both G band and 2D band are observed and, therefore, it is apparent that the transparent conductive carbon film obtained in the present Example is a crystalline graphene film. In the case of graphite, which is a bulky crystalline carbon material, the 2D band shows a shape having a shoulder on the low wavenumber side. In the case of a graphene film, it shows a symmetrical shape. The peak width of the left half of a peak and that of the right half of a peak of the 2D band in Fig. 20 were measured. As a result, the peak width of the left half was 38.3 cm⁻¹ and that of the right half was 35.2 cm⁻¹, thus it was found that a peak has almost symmetrical shape. As is apparent therefrom, the transparent conductive thin film of the present invention is a crystalline graphene film. It is considered that the D' band is a peak induced from defects, and is attributed to the edge portion of a laminate of an about several-to several tens-layer graphene film.

Furthermore, electric conductivity of a transparent conductive carbon film formed by the technique of the present invention obtained in the present Example was measured and, as a result, it was found that the transparent conductive carbon film has sheet resistance of (1 to 8) × 10⁵ Ω/sq.

### [Reference Signs List]

- 101:: Plasma generation chamber
- 102:: Rectangular microwave wave guide tube with slot
- 103:: Quartz window for introducing microwave
- 104:: Supporting member made of metal, which supports quartz window
- 105:: Base material
- 106:: Sample stage on which base material is disposed
- 107:: Supply/drain tube of cooling water
- 108:: Exhaust tube
- 109:: Gas introduction tube for CVD treatment
- 110:: Reaction vessel
- 111:: Cooling water tube
- 200:: Discharge vessel
- 201:: Rectangular wave guide
- 202:: Slot antenna
- 203:: Quartz window
- 204:: Base material
- 205:: Sample stage
- 206:: Reaction chamber

## Claims

1. A method for producing a transparent conductive carbon film, which comprises the steps of:
preparing a base material wound around a first roll, wherein the base material is acopper foil or an aluminum foil,
drawing the base material from the first roll and introducing the base material into a microwave surface-wave plasma CVD apparatus through a first differential evacuation portion,
depositing a transparent conductive carbon film on a surface of the base material using the microwave surface-wave plasma CVD apparatus by setting the temperature of the base material to 500°C or lower and the pressure to 50 Pa or less in a gas atmosphere in which an oxidation inhibitor as an additive gas for suppressing oxidation of the surface of the base material is added to a carbon-containing gas or a mixed gas of a carbon-containing gas and an inert gas,
taking out the base material with the transparent conductive carbon film deposited thereon from the microwave surface-wave plasma CVD apparatus through a second differential evacuation portion, and
taking up the transparent conductive carbon film deposited on the base material on a second roll,
wherein the microwave surface-wave plasma is generated by a microwave-generated surface-wave,

2. The method for producing a transparent conductive carbon film according to Claim 1, which further comprises the step of removing the carbon film from the base material on which the transparent conductive carbon film is deposited, by dissolving the base material by ferric chloride solution, wherein the differential evacuation portion on the side of the first roll maintains pressure and temperature.

3. The method for producing a transparent conductive carbon film according to Claim 1, which further comprises a step of transferring the base material on which the transparent conductive carbon film is deposited to another base material.

4. The method for producing a transparent conductive carbon film according to any one of Claims 1 to 3, wherein the additive gas is hydrogen, and also the concentration of the carbon-containing gas or the carbon-containing gas in the mixed gas is 30 to 100 mol% and the addition amount of the hydrogen gas is 1 to 20 mol% to the carbon-containing gas or the mixed gas.

5. The method for producing a transparent conductive carbon film according to any one of Claims 1 to 4, wherein the transparent conductive carbon films is deposited with multi-layer graphene, by a plasma CVD treatment depositing the transparent conductive carbon film having a thickness of several layers.

## Patentansprüche

1. Ein Verfahren zur Herstellung eines transparenten, leitenden Kohlenstoff-Films welches die Verfahrenschritte beinhaltet:
vorbereiten eines um eine erste Rolle gewickelten Basismaterials, wobei das Basismaterial Kupferfolie oder Aluminiumfolie ist,
abziehen des Basismaterials von der ersten Rolle und einführen des Basismaterials in ein erstes differentielles Evakuationsteil eines Mikrowellen-Oberflächenwellen-Plasma-CVD Gerätes,
auftragen eines transparenten, leitenden Kohlenstoff-Films auf eine Oberfläche des Basismaterials mittels eines Mikrowellen-Oberflächenwellen-Plasma-CVD Gerätes,
indem die Temperatur des Basismaterials auf 500°C oder weniger festgelegt wird und der Druck auf 50 Pa oder weniger festgelegt wird in einer Gasatmospähre in welcher ein Oxidationshemmer als ein zusätzliches Gas, um Oxidation der Oberfläche des Basismaterials zu unterdrücken, beigefügt ist zu einem kohlenstoffhaltigem Gas oder
einer Gasmischung aus kohlenstoffhaltigem und inertem Gas,
entnehmen des Basismaterials mit dem darauf aufgetragenen transparenten leitenden Kohlenstoff-Films aus dem Mikrowellen-Oberflächenwellen-Plasma-CVD Gerät durch ein zweites differentielles Evakuationsteil und
aufrollen auf eine zweite Rolle des auf dem Basismaterial aufgetragenen transparenten leitenden Kohlenstoff-Filmes,
wobei das Mikrowellen-Oberflächenwellen-Plasma von einer Mikrowellen erzeugten Oberfächenwelle erzeugt wird.

2. Das Herstellungsverfahren eines transparenten, leitenden Kohlenstoff-Films nach Anspruch 1, beinhaltet den Verfahrensschritt, den Kohlenstoff-Film von dem Basismaterial auf dem der transparente, leitende Kohlenstoff-Film aufgetragen ist, zu entfernen, indem das Basismaterial aufgelöst wird durch eine Eisenchloridlösung, wobei das differentielle Evakuationsteil der ersten Rolle Druck und Temperatur beibehält.

3. Das Herstellungsverfahren eines transparenten leitenden Kohlenstoff-Films nach Anspruch 1, welches weiterhin den Verfahrensschritt umfasst, das Basismaterial auf dem der transparente, leitende Kohlenstoff-Film aufgetragen ist, auf ein anderes Basismaterial zu übertragen.

4. Das Herstellungsverfahren eines transparenten, leitenden Kohlenstoff-Films nach irgend einem der Ansprüche 1 bis 3, wobei das zusätzliche Gas Wasserstoff ist, und auch die Konzentration des kohlenstoffhaltigen Gases oder dem kohlenstoffhaltigem Gas in der Gasmischung ist 30 bis 100 mol% und die Beigabe des Wasserstoffgases zu dem kohlenstoffhaltigem Gase oder der Gasmischung ist 1 bis 20 mol%

5. Das Herstellungsverfahren eines transparenten, leitenden Kohlenstoff-Films nach irgend einem der Ansprüche 1 bis 4, wobei der transparente, leitende Kohlenstoff-Film in Mehrlagen-Graphen aufgetragen ist mit einer Plasma-CVD Behandlung, welche den transparenten, leitenden Kohlenstoff-Film mit einer Dicke von einingen Schichten aufträgt.

## Revendications

1. Procédé de production d'un film de carbone conducteur transparent, qui comprend les étapes consistant à :
préparer un matériau de base enroulé autour d'un premier rouleau, le matériau de base étant une feuille de cuivre ou une feuille d'aluminium,
tirer le matériau de base depuis le premier rouleau et introduire le matériau de base dans un appareil de CVD assisté par plasma d'onde de surface à micro-ondes par une première partie d'évacuation différentielle,
déposer un film de carbone conducteur transparent sur une surface du matériau de base en utilisant l'appareil de CVD assisté par plasma d'onde de surface à micro-ondes en réglant la température du matériau de base à 500 °C ou moins et la pression à 50 Pa ou moins dans une atmosphère gazeuse dans laquelle un inhibiteur d'oxydation en tant qu'additif gazeux pour supprimer l'oxydation de la surface du matériau de base est ajouté à un gaz contenant du carbone ou un gaz mixte d'un gaz contenant du carbone et d'un gaz inerte,
sortir le matériau de base avec le film de carbone conducteur transparent déposé sur celui-ci de l'appareil de CVD assisté par plasma d'onde de surface à micro-ondes par une deuxième partie d'évacuation différentielle, et
reprendre le film de carbone conducteur transparent déposé sur le matériau de base sur un deuxième rouleau,
dans lequel le plasma d'onde de surface à micro-ondes est généré par une onde de surface générée par micro-ondes.

2. Procédé de production d'un film de carbone conducteur transparent selon la revendication 1, qui comprend en outre l'étape consistant à retirer le film de carbone du matériau de base sur lequel le film de carbone conducteur transparent est déposé en dissolvant le matériau de base par une solution de chlorure ferrique, dans lequel la partie d'évacuation différentielle sur le côté du premier rouleau maintient la pression et la température.

3. Procédé de production d'un film de carbone conducteur transparent selon la revendication 1, qui comprend en outre l'étape consistant à transférer le matériau de base sur lequel le film de carbone conducteur transparent est déposé à un autre matériau de base.

4. Procédé de production d'un film de carbone conducteur transparent selon l'une quelconque des revendications 1 à 3, dans lequel l'additif gazeux est l'hydrogène, et la concentration du gaz contenant du carbone ou du gaz contenant du carbone dans le gaz mixte est de 30 à 100 % en moles et la quantité d'addition de l'hydrogène gazeux au gaz contenant du carbone ou au gaz mixte est de 1 à 20 % en moles.

5. Procédé de production d'un film de carbone conducteur transparent selon l'une quelconque des revendications 1 à 4, dans lequel le film de carbone conducteur transparent est déposé avec du graphène multicouche, par un traitement de CVD assisté par plasma déposant le film de carbone conducteur transparent ayant une épaisseur de plusieurs couches.
